# EUROPEAN PATENT SPECIFICATION

(11) **EP 2 375 184 B1**
(45) Date of publication and mention of the grant of the patent: **07.10.2015**
(21) Application number: 10729097.5
(22) Date of filing: 05.01.2010
(51) Int. Cl.: F24J 2/00

(54) **LARGE TRACKING-TYPE FRESNEL LENS POINT-FOCUSING SOLAR SYSTEM**
SOLARSYSTEM ZUR PUNKTFOKUSSIERUNG EINER GROSSEN SCHIENEN-FRESNELLINSE
SYSTÈME SOLAIRE À CONCENTRATION EN UN POINT PAR LENTILLE DE FRESNEL DE TYPE À GRANDE PORTÉE

(30) Priority: 06.01.2009 CN 200910058051
(43) Date of publication of application: 12.10.2011
(73) Proprietor: Chengdu Zsun Science And Technology Developing Co., Ltd., Sichuan 610065 (CN)
(72) Inventor: HUANG, Zhong, Sichuan 610065 (CN); LI, Xiangyang, Sichuan 610065 (CN)
(74) Representative: Vandeberg, Marie-Paule L.G.
(86) International application number: PCT/CN2010/070017
(87) International publication number: WO 2010/078838

(56) References cited:
- WO-A2-2005/074041
- CN-A- 1 160 441
- CN-A- 1 930 693
- CN-A- 101 098 115
- CN-Y- 2 913 955
- DE-A1- 19 854 391
- US-A- 4 210 121
- US-A- 4 700 013
- US-A- 4 723 535
- US-A- 4 892 593
- US-A1- 2002 121 298
- US-A1- 2007 295 384
- US-A1- 2008 092 877

## Description

### Technical field

The invention relates to a tracking type Fresnel lens point-focusing solar power system, belonging to the field of combined solar power photothermic and photoelectric applications.

### Technical background

Solar power is an important part of new energy resources and renewable energy resources. There is great market prospect for the exploitation of the solar energy resources. It not only has sound social and environmental effects but also has obvious economic value. The exploitation methods of the solar energy are mainly divided into photothermic conversion, photoelectric conversion, and combined photothermic and photoelectric conversion. In order to take full advantage of solar energy, people have attached more and more importance to the exploitation method of photothermic and photoelectric conversion.

In China, few inventions relate to utilization methods of the photothermic and photoelectric conversion and they are as follows: Patent Application No. 200810044255.2 relates to a crystal silicon solar cell component photothermic and photoelectric utilization system, and Patent Application No. 200710063481.0 relates to a solar energy photothermic and photoelectric integration aggregation machine. In the photoelectric and photothermic utilization techniques of the abovementioned patents, all the heat energy is obtained through the method that solar cells are cooled with cooling liquid; meanwhile, the tracking aggregation techniques are not adopted. The abovementioned technical proposals have the following disadvantages: - as the trailing aggregation techniques are not adopted, the use ratio of solar energy is not high; - relatively high energy levels cannot be obtained by the method wherein solar cells are cooled with cooling liquid; furthermore, it has heat energy with low temperature being less than 100°C; - The adopted cell component is an unconventional component needing to be redesigned and reassembled; therefore, it implies complicated techniques and high difficulty for the realization.

99.9% energy of solar electromagnetic radiation is concentrated in infrared region, visible region and ultraviolet region. The wavelength range of solar radiation which can convert the optical energy to electric energy through photovoltaic cells is about 0.2∼1.25 µm, that is, the light is in a part of the ultraviolet, visible light and near infrared regions. The invention adopts tracking concentrating technique to improve the use ratio. Furthermore, a sunlight selective transmission technique is adopted; therefore, visible light is transmitted; most of infrared light is reflected, and the energy of each wave band of the solar spectrum can be fully utilized.

A further document reflecting the state of the art is represented by US 2002121298 A.

### Summary of the invention

The object of the invention is to provide a tracking type big Fresnel lens point-focusing solar power system. It is a photothermic and photoelectric conversion system which can precisely track the sun, utilize the sunlight according to the wave bands, concentrate heat by high power, and concentrate light by medium and low powers.

This object is solved by the features of claim 1.

The subject of the invention comprises a box body, a point-focusing glass matrix Fresnel lens, a reflective low-emissivity glass, a photovoltaic component, a high-temperature heat accumulator and a tracker, wherein the point-focusing glass Fresnel lens, the reflective low-emissivity glass and the photovoltaic component are arranged in proper sequence from up to down, and respectively arranged on the upper part, the middle part and the low part of the box body. It is preferable that the reflective low-emissivity glass is positioned within the range of 2/5~3/5 of the focal length of the point-focusing glass matrix Fresnel lens. The high-temperature heat accumulator is positioned above the point-focusing glass matrix Fresnel lens. The high-temperature heat accumulator is fixed and arranged on a transverse bracket connected with the box body, and the whole box body is arranged on the tracker.

The box body is driven by a tracker, so that the sunlight can always irradiate at right angle to the point-focusing glass matrix Fresnel lens. After the sunlight is transmitted through the point-focusing glass matrix Fresnel lens, it focuses and irradiates the reflective low-emissivity glass. With the features of sunlight selective-transmission of the reflective low-emissivity glass, for the sunlight irradiating on the reflective low-emissivity glass, most of the infrared is reflected and irradiates the high-temperature heat accumulator, and the rest of the sunlight is transmitted and irradiates the photovoltaic component. It might be as well that it focuses again through second lens and irradiates the photovoltaic component.

### Descriptions of the drawings

The invention is further described with the following drawings;
Figure 1 is a structure diagram of an embodiment of the invention.
Figure 2 is a principle diagram of an embodiment of the invention.

Reference numbers in the figures:
- 1.: Box body;
- 2.: Point-focusing glass matrix Fresnel lens;
- 3.: Elevation-angle regulation mechanism;
- 4.: Supporting frame;
- 5.: Standing column;
- 6.: Azimuth-angle regulation mechanism;
- 7.: Transverse bracket;
- 8.: High-temperature heat accumulator;
- 9.: Reflective low-emissivity glass;
- 10.: Photovoltaic component.

### Detailed description of the invention

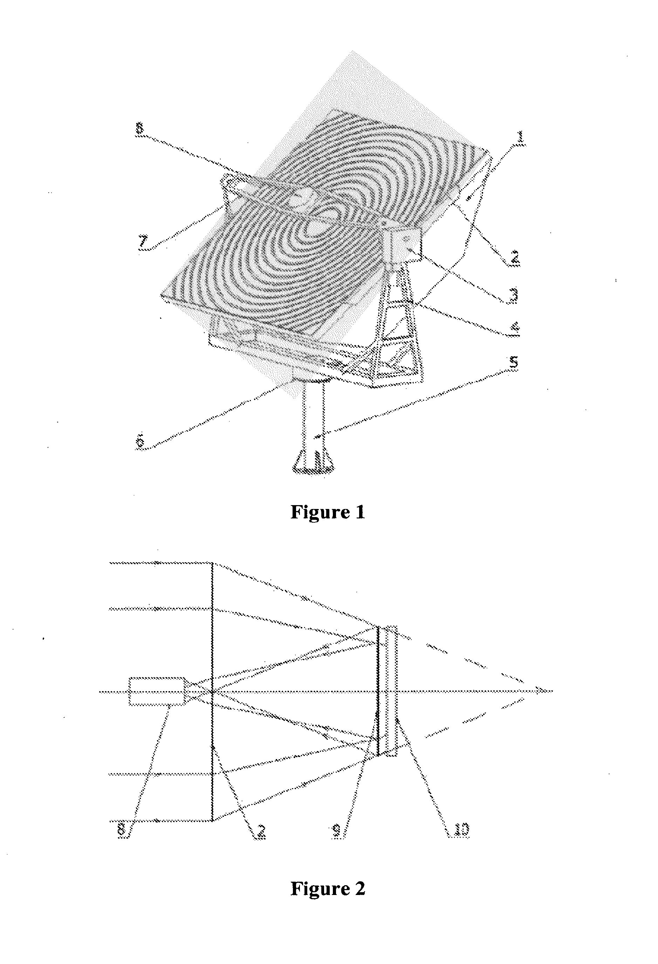

Referring to Figure 1 and 2, the embodiment of the invention comprises a box body 1, a point-focusing glass matrix Fresnel lens 2, a reflecting low-radiation glass 9, a photovoltaic component 10, a high-temperature heat accumulator 8 and a tracker. The point-focusing glass matrix Fresnel lens 2, the reflecting low-radiation glass 9 and the photovoltaic component 10 are arranged in proper sequence from up to down and respectively arranged on the upper part, middle part and lower part of the box body 1. The reflective low-emissivity glass 9 is positioned at 1/2 of the focal length of the point-focusing glass matrix Fresnel lens 2, and the photovoltaic component 10 is tightly attached to the reflective low-emissivity glass 9. The high-temperature heat accumulator 8 is positioned above the point-focusing glass matrix Fresnel lens 2. The high-temperature heat accumulator 8 is fixed and arranged on the transverse bracket 7 connected with the box body 1. The box body 1 is arranged on the tracker. The box body 1 is driven by the tracker, so that the sunlight can be guaranteed to always perpendicularly irradiate the point-focusing glass matrix Fresnel lens 2. The sunlight is transmitted through the point-focusing glass matrix Fresnel lens 2, focuses and irradiates the reflective low-emissivity glass 9. For the sunlight irradiating the reflective low-emissivity glass 9, most of infrared is reflected and irradiates the high-temperature heat accumulator 8, while the rest of the sunlight is transmitted and irradiates the photovoltaic component 10.

The above-mentioned tracker consists of a standing column 5, an azimuth-angle regulation mechanism 6, an elevation-angle regulation mechanism 3 and a supporting frame 4. The azimuth-angle regulation mechanism 6 is arranged on the upper end of the stand column 5. The supporting frame 4 is arranged on the azimuth-angle regulation mechanism 6.

The rotation shaft of the above-mentioned box body 1 is arranged on the supporting frame 4, and connected with the elevation-angle regulation mechanism 3.

The above-mentioned reflective low-emissivity glass 9 is made of ultra-white and float plate glass materials which have high-reflectivity for light in solar spectrum with the wavelength being more than or equal to 1.25 µ m and have high-transmittance for visible light.

The heat-absorbing surface of the above-mentioned high-temperature heat accumulator 8 is made of ceramic material with heat resisting performance and high thermal conductivity. Its main body is made of heat conducting and thermal storage materials with high-temperature and stable good performances.

Although the preferred embodiments of the present invention have been disclosed for illustrative purposes, those skilled in the art will appreciate that various modifications, additions and substitutions are possible, without departing from the scope of the invention as disclosed in the accompanying claims.

## Claims

1. A tracking- type big Fresnel lens point-focusing solar power system, comprising a box body (1), a point-focusing glass matrix Fresnel lens (2), a piece of reflective low-emissivity glass (9), a photovoltaic component (10), a high-temperature heat accumulator (8),
the point-focusing glass matrix Fresnel lens (2), the reflective low-emissivity glass (9) and the photovoltaic component (10) being arranged in proper sequence from up to down, and respectively arranged on the upper part, the middle part and the lower part of the box body (1), **characterized in that** the high-temperature heat accumulator (8) is positioned above the point-focusing glass matrix Fresnel lens (2), the high-temperature heat accumulator (8) being fixed and arranged on a transverse bracket (7) connected with the box body (1), the box body (1) being arranged on a tracker.

2. A tracking-type big Fresnel lens point-focusing solar power system according to claim 1, **characterized in that** the tracker comprises a standing column (5), an azimuth-angle regulation mechanism (6), an elevation-angle regulation mechanism (3) and a supporting frame (4), the azimuth-angle regulation mechanism (6) being arranged on the upper end of the standing column (5), the supporting frame (4) being arranged on the azimuth-angle regulation mechanism (6).

3. A tracking-type big Fresnel lens point-focusing solar power system according to claim 2, **characterized in that** a rotation shaft of the box body (1) is arranged on the supporting frame (4) and connected with the elevation-angle regulation mechanism (3).

4. A tracking-type big Fresnel lens point-focusing solar power system according to any one of the preceding claims, **characterized in that** the reflective low-emissivity glass (9) is made of ultra-white and float plate glass materials which have infrared light high reflectivity and visible light high transmittance.

5. A tracking-type big Fresnel lens point-focusing solar power system according to any one of the preceding claims, **characterized in that** the heat-absorbing surface of the high-temperature heat accumulator is made of ceramic material with heat resisting performance and high thermal conductivity, its main body being made of heat conducting and thermal storage materials with good stability under high temperature.

6. A tracking-type big Fresnel lens point-focusing solar power system according to any one of the preceding claims, **characterized in that** the reflective low-emissivity glass (9) is positioned within the range of 2/5~3/5 of the focal length of the point-focusing glass matrix Fresnel lens (2).

7. A tracking-type big Fresnel lens point-focusing solar power system according to claim 6, **characterized in that** the reflective low-emissivity glass (9) is positioned at 1/2 of the focal length of the point-focusing glass matrix Fresnel lens (2).

## Patentansprüche

1. Punktkonzentrierende Solarstromanlage nachgeführter Art mit großer Fresnel-Linse, umfassend einen kastenförmigen Körper (1), eine punktkonzentrierende Glasmatrix-Fresnel-Linse (2), ein Stück reflektierendes emissionsarmes Glas (9), ein photovoltaisches Bauteil (10) und einen Hochtemperatur-Wärmespeicher (8),
wobei die punktfokussierende Glasmatrix-Fresnel-Linse (2), das reflektierende emissionsarme Glas (9) und das photovoltaische Bauteil (10) von oben nach unten in der richtigen Reihenfolge angeordnet sind und jeweils auf dem oberen Teil, dem mittleren Teil und dem unteren Teil des kastenförmigen Körpers (1) angeordnet sind,
**dadurch gekennzeichnet, dass** der Hochtemperatur-Wärmespeicher (8) über der punktkonzentrierenden Glasmatrix-Fresnel-Linse (2) positioniert ist, wobei der Hochtemperatur-Wärmespeicher (8) an einer Querhalterung (7) befestigt und darauf angeordnet ist, die mit dem kastenförmigen Körper (1) verbunden ist, wobei der kastenförmige Körper (1) an einer Nachführvorrichtung angeordnet ist.

2. Punktkonzentrierende Solarstromanlage nachgeführter Art mit großer Fresnel-Linse nach Anspruch 1, **dadurch gekennzeichnet, dass** die Nachführvorrichtung eine Standsäule (5), einen Azimutwinkel-Regulierungsmechanismus (6), einen Erhebungswinkel-Regulierungsmechanismus (3) und einen Trägerrahmen (4) umfasst, wobei der Azimutwinkel-Regulierungsmechanismus (6) an dem oberen Ende der Standsäule (5) angeordnet ist, wobei der Trägerrahmen (4) an dem Azimutwinkel-Regulierungsmechanismus (6) angeordnet ist.

3. Punktkonzentrierende Solarstromanlage nachgeführter Art mit großer Fresnel-Linse nach Anspruch 2, **dadurch gekennzeichnet, dass** eine Drehwelle des kastenförmigen Körpers (1) an dem Trägerrahmen (4) angeordnet ist und mit dem Erhebungswinkel-Regulierungsmechanismus (3) verbunden ist.

4. Punktkonzentrierende Solarstromanlage nachgeführter Art mit großer Fresnel-Linse nach einem der vorhergehenden Ansprüche, **dadurch gekennzeichnet, dass** das reflektierende emissionsarme Glas (9) aus ultraweißen und schwingungsfreien Glasplattenmaterialien besteht, die ein hohes Reflexionsvermögen für Infrarotlicht und einen hohen Transmissionsgrad für sichtbares Licht aufweisen.

5. Punktkonzentrierende Solarstromanlage nachgeführter Art mit großer Fresnel-Linse nach einem der vorhergehenden Ansprüche, **dadurch gekennzeichnet, dass** die wärmeabsorbierende Oberfläche des Hochtemperatur-Wärmespeichers aus Keramikmaterial mit Wärmebeständigkeitsleistung und hoher Wärmeleitfähigkeit besteht, wobei ihr Körper aus wärmeleitenden und wärmespeichernden Materialien mit guter Stabilität bei hohen Temperaturen besteht.

6. Punktkonzentrierende Solarstromanlage nachgeführter Art mit großer Fresnel-Linse nach einem der vorhergehenden Ansprüche, **dadurch gekennzeichnet, dass** das reflexionsarme Glas (9) in dem Bereich von 2/5 bis 3/5 der Brennweite der punktkonzentrierenden Glasmatrix-Fresnel-Linse (2) positioniert ist.

7. Punktkonzentrierende Solarstromanlage nachgeführter Art mit großer Fresnel-Linse nach Anspruch 6, **dadurch gekennzeichnet, dass** das reflektierende emissionsarme Glas (9) bei 1/2 der Brennweite der punktkonzentrierenden Glasmatrix-Fresnel-Linse (2) positioniert ist.

## Revendications

1. Système à énergie solaire à focalisation ponctuelle par grande lentille de Fresnel du type à poursuite, comprenant un corps de boîtier (1), une lentille de Fresnel à matrice de verre à focalisation ponctuelle (2), un élément de verre réfléchissant à faible émissivité (9), un composant photovoltaïque (10), un accumulateur de chaleur de haute température (8), la lentille de Fresnel à matrice de verre à focalisation ponctuelle (2), le verre réfléchissant à faible émissivité (9) et le composant photovoltaïque (10) étant disposés dans une séquence appropriée de haut en bas, et disposés respectivement sur la partie supérieure, la partie médiane et la partie inférieure du corps de boîtier (1), **caractérisé par le fait que** l'accumulateur de chaleur de haute température (8) est positionné au-dessus de la lentille de Fresnel à matrice de verre à focalisation ponctuelle (2), l'accumulateur de chaleur de haute température (8) étant fixé et disposé sur un support transversal (7) relié au corps de boîtier (1), le corps de boîtier (1) étant disposé sur un dispositif de poursuite.

2. Système à énergie solaire à focalisation ponctuelle par grande lentille de Fresnel du type à poursuite selon la revendication 1, **caractérisé par le fait que** le dispositif de poursuite comprend une colonne dressée (5), un mécanisme de régulation d'angle d'azimut (6), un mécanisme de régulation d'angle d'élévation (3) et un châssis de support (4), le mécanisme de régulation d'angle d'azimut (6) étant disposé sur l'extrémité supérieure de la colonne dressée (5), le châssis de support (4) étant disposé sur le mécanisme de régulation d'angle d'azimut (6).

3. Système à énergie solaire à focalisation ponctuelle par grande lentille de Fresnel du type à poursuite selon la revendication 2, **caractérisé par le fait qu'**un arbre de rotation du corps de boîtier (1) est disposé sur le châssis de support (4) et relié au mécanisme de régulation d'angle d'élévation (3).

4. Système à énergie solaire à focalisation ponctuelle par grande lentille de Fresnel du type à poursuite selon l'une quelconque des revendications précédentes, **caractérisé par le fait que** le verre réfléchissant à faible émissivité (9) est fait de matériaux de verre en plaque ultra-blanc et flotté qui ont une réflectivité élevée de lumière infrarouge et une transmittance élevée de lumière visible.

5. Système à énergie solaire à focalisation ponctuelle par grande lentille de Fresnel du type à poursuite selon l'une quelconque des revendications précédentes, **caractérisé par le fait que** la surface absorbant la chaleur de l'accumulateur de chaleur de haute température est faite de matière céramique ayant une performance de résistance à la chaleur et une conductivité thermique élevée, son corps principal étant fait de matières conduisant la chaleur et de stockage thermique avec une bonne stabilité sous une température élevée.

6. Système à énergie solaire à focalisation ponctuelle par grande lentille de Fresnel du type à poursuite selon l'une quelconque des revendications précédentes, **caractérisé par le fait que** le verre réfléchissant à faible émissivité (9) est positionné dans la plage de 2/5 ~ 3/5 de la longueur focale de la lentille de Fresnel à matrice de verre à focalisation ponctuelle (2).

7. Système à énergie solaire à focalisation ponctuelle par grande lentille de Fresnel du type à poursuite selon la revendication 6, **caractérisé par le fait que** le verre réfléchissant à faible émissivité (9) est positionné à 1/2 de la longueur focale de la lentille de Fresnel à matrice de verre à focalisation ponctuelle (2).
